# EUROPÄISCHE PATENTANMELDUNG

(11) **EP 4 109 115 A1**
(43) Veröffentlichungstag der Anmeldung: **28.12.2022**
(21) Anmeldenummer: 22181065.8
(22) Anmeldetag: 24.06.2022
(51) Int. Cl.: G01R 15/20

(54) **STROMERFASSUNGSANORDNUNG, KOMMUTIERZELLE UND WECHSELRICHTER**

(30) Priorität: 25.06.2021 DE 102021206627
(71) Anmelder: Robert Bosch GmbH, 70442 Stuttgart (DE)
(72) Erfinder: Homoth, Jan, 72770 Reutlingen (DE); Harsanyi, Balazs Bence, 74321 Bietigheim-Bissingen (DE); Rock, Sebastian, 72070 Tuebingen (DE); Braun, Gerhard, 72108 Rottenburg (DE); Strache, Sebastian, 72827 Wannweil (DE)

(57) **Zusammenfassung**

Die Erfindung betrifft eine Stromerfassungsanordnung. Die Stromerfassungsanordnung weist einen insbesondere keramischen Schaltungsträger auf. Der Schaltungsträger weist wenigstens eine, oder nur eine elektrisch isolierende Schicht, und wenigstens eine elektrisch leitfähige Schicht auf. Der Schaltungsträger weist eine mit der elektrisch isolierenden Schicht isolierend verbundene elektrisch leitfähige Rückseitenschicht auf, welche ausgebildet ist, mit einer Wärmesenke wärmeleitfähig verbunden zu werden. Die elektrisch leitfähige Schicht des Schaltungsträgers bildet eine Leiterbahn, welche ausgebildet ist, einen Strom zu führen. Die Stromerfassungsanordnung weist auch einen mit dem Schaltungsträger verbundenen Stromsensor zum Erfassen des in der Leiterbahn fließenden Stromes auf. Der Stromsensor ist im Bereich der Leiterbahn angeordnet und ausgebildet, ein von dem in der Leiterbahn fließenden Strom erzeugten Magnetfeld zu erfassen. Erfindungsgemäß weist die elektrisch leitfähige Rückseitenschicht der Stromerfassungsanordnung im Bereich des Stromsensors wenigstens eine oder nur eine Aussparung auf.

## Beschreibung

### Stand der Technik

Die Erfindung betrifft eine Stromerfassungsanordnung, eine die Stromerfassungsanordnung umfassende Kommutierzelle und einen die Kommutierzelle umfassenden Wechselrichter. Die Stromerfassungsanordnung weist einen insbesondere keramischen Schaltungsträger auf. Der Schaltungsträger weist wenigstens eine, oder nur eine elektrisch isolierende Schicht, und wenigstens eine elektrisch leitfähige Schicht auf. Der Schaltungsträger weist eine mit der elektrisch isolierenden Schicht isolierend verbundene elektrisch leitfähige Rückseitenschicht auf, welche ausgebildet ist, mit einer Wärmesenke wärmeleitfähig verbunden zu werden.

Die elektrisch leitfähige Schicht des Schaltungsträgers bildet eine Leiterbahn, welche ausgebildet ist, einen Strom zu führen.

Die Stromerfassungsanordnung weist auch einen mit dem Schaltungsträger verbundenen Stromsensor zum Erfassen des in der Leiterbahn fließenden Stromes auf. Der Stromsensor ist im Bereich der Leiterbahn angeordnet und ausgebildet, ein von dem in der Leiterbahn fließenden Strom erzeugten Magnetfeld zu erfassen.

Aus der DE 600 2768 T2 ist ein Stromsensor mit einem Hall-Sensor bekannt, welcher ausgebildet ist, einen in einer Strombahn fließenden Strom zu erfassen.

### Offenbarung der Erfindung

Erfindungsgemäß weist die elektrisch leitfähige Rückseitenschicht der Stromerfassungsanordnung der eingangs genannten Art im Bereich des Stromsensors, insbesondere in einem zu dem Stromsensor gegenüberliegenden Bereich, wenigstens eine oder nur eine Aussparung auf. Vorteilhaft kann so ein in der elektrisch leitfähigen Schicht erzeugter Wirbelstrom - insbesondere im Bereich des Stromsensors - im Vergleich zu einer Schicht ohne die Aussparung reduziert sein.

Es wurde nämlich erkannt, dass im Bereich des Stromsensors in der Leiterbahn eine erhöhte Stromdichte auftritt, welche in Verbindung mit den in der Rückseitenschicht in diesem Bereich ausgebildeten Wirbelströmen sowohl erhöhte elektrische Verluste, als auch eine Erwärmung des Schaltungsträgers bewirkt. Weiter vorteilhaft kann so eine verbesserte Frequenzbandbreite der Stromübertragung gebildet sein, insoweit der Wirbelstrom eine unerwünschte Phasenverschiebung zwischen dem Strom in der Leiterbahn und dem erzeugten Magnetfeld bewirkt und weiter nachteilig eine Stromamplitude reduziert.

Vorteilhaft kann durch die Ausnehmung sowohl die Erwärmung, als auch die Wirbelstromausbildung reduziert, oder verhindert sein.

Bevorzugt deckt die Ausnehmung den Flächenbereich der Hallsensoren ab. Vorteilhaft kann das von den Hallsensoren erfasste Magnetfeld so in die Aussparung hineinreichen. In einer vorteilhaften Ausführungsform weist die Rückseitenschicht für jeden Hallsensor eine Aussparung auf, welche im Bereich des Hallsensors, insbesondere einer Projektion des Hallsensors auf die Rückseitenschicht, ausgebildet ist. Vorteilhaft kann das Feld so für jeden Hallsensor durch die Rückseitenschicht hindurchreichen und wenigstens im Bereich des Hallsensors weniger oder keine Wirbelströme in dem Schaltungsträger ausbilden.

Bevorzugt schließen die Rückseitenschicht und die elektrisch leitfähige Schicht, insbesondere Kupferschicht, die elektrisch isolierende Schicht zwischeneinander ein. Weiter bevorzugt sind die elektrisch leitfähige Schicht, insbesondere die Leiterbahn, und die Rückseitenschicht mit der elektrisch isolierenden Schicht, insbesondere einer Keramikschicht, stoffschlüssig verbunden, beispielsweise versintert. Vorteilhaft kann die Stromerfassungsanordnung so kompakt ausgebildet sein. Der Stromsensor kann beispielsweise im Bereich der Leiterbahn auf einem weiteren Schaltungsträger angeordnet sein, welcher sich zu dem Schaltungsträger mit der Leiterbahn parallel erstreckt. Der weitere Schaltungsträger ist beispielsweise durch eine Leiterplatte, eine flexible Leiterplatte, insbesondere FCB (FCB = Flexible-Circuit-Board), oder einen LTCC-Schaltungsträger, oder HTCC-Schaltungsträger gebildet. Der weitere Schaltungsträger ist bevorzugt mit dem Schaltungsträger verlötet, verklebt oder versintert, oder mittels eines Abstandshalters mit dem Schaltungsträger bevorzugt stoffschlüssig verbunden.

In einer bevorzugten Ausführungsform ist mittels der Aussparung eine sich entlang einer Schichtdicke der Rückseitenschicht gebildete Wanne oder Vertiefung gebildet. Bevorzugt weist die Rückseitenschicht im Bereich der Aussparung eine kleinere Schichtdicke auf, als in einem die Aussparung umgebenden Bereich. Vorteilhaft kann die Aussparung so aufwandsgünstig durch Ätzen, oder durch Laserablation erzeugt werden.

Bevorzugt ist die Vertiefung oder Aussparung in einer Schaltungsträgerebene des Schaltungsträgers rechteckig, kreisrund oder oval gebildet. Vorteilhaft kann die Aussparung so aufwandsgünstig durch Fräsen oder Laserablation gebildet sein.

In einer vorteilhaften Ausführungsform ist die Aussparung durch einen Streifen gebildet, welcher sich - insbesondere geradlinig - zwischen zwei zueinander verschiedenen Rändern des Schaltungsträgers erstreckt. Die Aussparung kann so aufwandsgünstig durch Schleifen oder Längsfräsen erzeugt sein.

In einer bevorzugten Ausführungsform ist die Aussparung als Durchbruch in der Rückseitenschicht ausgebildet. Vorteilhaft kann im Bereich des Durchbruchs kein Wirbelstrom erzeugt werden. Der Durchbruch ist beispielsweise mittels Laserablation, oder mittels Ätzen, oder mittels Stanzen der Kupferschicht erzeugt.

In einer bevorzugten Ausführungsform ist die Aussparung mit einer Vergussmasse, insbesondere Mold-Masse, gefüllt. Vorteilhaft kann die Aussparung so zusammen mit der mit dem Schaltungsträger verbundenen elektrischen Schaltung, insbesondere elektronischen Bauelementen, in denen Mold-Körper eingebettet sein.

In einer bevorzugten Ausführungsform ist die Aussparung mit einem von der Rückseitenschicht verschiedenen elektrisch leitfähigen Material gefüllt. Bevorzugt ist das verschiedene Material ein insbesondere eingeschmolzenes Lotmittel, insbesondere Lötzinn. Vorteilhaft kann in der Aussparung so ein größerer elektrischer Widerstand zur Reduzierung des Wirbelstroms gebildet sein, als in dem die Aussparung umgebenden Schichtbereich. Die Rückseitenschicht ist bevorzugt durch eine Kupferschicht gebildet. In einer vorteilhaften Ausführungsform ist das verschiedene Material durch ein Inlay, insbesondere Harzinlay, beispielsweise faserverstärktes Epoxidharz gebildet. Vorteilhaft kann so eine Füllung der Aussparung mit einem zu der umgebenden Kupferschicht ähnlichen oder gleichen Wärmeausdehnungskoeffizienten in der Aussparung gebildet sein.

Der Schaltungsträger ist bevorzugt ein DCB-Schaltungsträger, AMB-Schaltungsträger (AMB = Active-Metal-Brazed), ein IMS-Schaltungsträger (IMS = Insulated-Metal-Substrate), oder ein DCB-Schaltungsträger (DCB = Direct-Copper-Bonded). Die elektrisch isolierende Keramikschicht des Schaltungsträgers ist bevorzugt eine Aluminiumoxidschicht oder Siliziumnitridschicht.

In einer bevorzugten Ausführungsform ist der Stromsensor ein differenzierender Hall-Sensor, umfassend wenigstens zwei oder nur zwei Sensorelemente, insbesondere Hall-Sensorelemente. Vorteilhaft kann der Strom so genau erfasst werden.

In einer bevorzugten Ausführungsform ist die Leiterbahn im Bereich des Stromsensors mäanderförmig ausgebildet. Vorteilhaft kann so eine Feldverstärkung durch die so gewundene Leiterbahn zum Erfassen des Stromes in der Leiterbahn gebildet sein.

In einer bevorzugten Ausführungsform ist die Leiterbahn im Bereich des Stromsensors S-förmig, oder M-förmig gebildet. Vorteilhaft kann eine Feldverstärkung so platzsparend in der Leiterbahnebene, und so in der Ebene des Schaltungsträgers, gebildet sein.

In einer vorteilhaften Ausführungsform ist die Leiterbahn im Bereich des Stromsensors als insbesondere einstückiges Leiterbahnelement ausgebildet, das mit dem Schaltungsträger, insbesondere einer Umverdrahtungsschicht des Schaltungsträgers, verlötet, versintert oder verklebt ist. Bevorzugt ist das Leiterbahnelement S-förmig, I-förmig oder W-förmig ausgebildet. Das Leiterbahnelement ist bevorzugt ein Kupferelement. Vorteilhaft kann die stromführende Leiterbahn, gebildet durch das Leiterbahnelement, so weiter von der Rückseitenschicht beabstandet sein, so dass das von dem Leiterbahnelement erzeugte Magnetfeld zum Erfassen durch den Stromsensor von der Rückseitenschicht weiter beabstandet ist als bei einer Leiterbahn zum Stromerfassen, die Bestandteil der Umverdrahtungsschicht ist.

Bevorzugt ist in einer sich zwischen den Mäanderschleifen der Leiterbahn erstreckenden Aussparungen ein Stromsensor, insbesondere Hall-Sensor angeordnet, welcher ausgebildet ist, ein in der Aussparung gebildetes Magnetfeld zu erfassen. Vorteilhaft kann so eine platzsparende Stromerfassungsanordnung gebildet sein.

In einer bevorzugten Ausführungsform ist die Leiterbahn im Bereich des Stromsensors I-förmig ausgebildet. Die Leiterbahn weist zur Ausbildung der I-Form bevorzugt wenigstens eine Verjüngung, oder wenigstens eine, oder zwei Aussparungen auf, welche sich quer zu einer Längserstreckung der Leiterbahn erstrecken, und so eine Verjüngung der Leiterbahn bewirken. Die Hall-Sensoren sind bevorzugt jeweils in einer Aussparung angeordnet. Vorteilhaft kann so aufwandsgünstig eine einfache Stromerfassungsanordnung gebildet sein.

Die Erfindung betrifft auch eine Kommutierzelle für einen Wechselrichter mit einer Stromerfassungsanordnung der vorbeschriebenen Art. Die Kommutierzelle umfasst wenigstens eine Halbleiterschalter-Halbbrücke, umfassend einen Low-Side-Halbleiterschalter und einen High-Side-Halbleiterschalter, wobei die Kommutierzelle ausgebildet ist, den Strom für eine Phase des Inverters zu erzeugen. Bevorzugt sind die Halbleiterschalter mit dem Schaltungsträger verbunden, insbesondere verlötet oder versintert.

Die Erfindung betrifft auch einen Wechselrichter für ein Elektrofahrzeug oder Hybridfahrzeug, wobei der Wechselrichter, auch Inverter genannt, für jede Phase eine Kommutierzelle der vorbeschriebenen Art aufweist. Der Wechselrichter ist ausgebildet, eine elektrische Maschine des Elektrofahrzeugs zum Erzeugen eines magnetischen Drehfeldes zu bestromen.

Die Erfindung wird nun im Folgenden anhand von Figuren und weiteren Ausführungsbeispielen beschrieben. Weitere vorteilhafte Ausführungsvarianten ergeben sich aus einer Kombination der in den Figuren und in den abhängigen Ansprüchen beschriebenen Merkmale.

Figur 1 zeigt ein Ausführungsbeispiel für eine Stromerfassungsanordnung, bei der ein Stromsensor auf einem Schaltungsträger angeordnet ist und einen in dem Schaltungsträger fließenden Strom erfassen kann, wobei ein durch den Strom erzeugtes Magnetfeld in einer Aussparung einer Rückseitenschicht des Schaltungsträgers keinen oder nur einen geringen Wirbelstrom erzeugen kann;

Figur 2 zeigt die in Figur 1 gezeigte Stromerfassungsanordnung in einer Aufsicht, wobei eine den zu erfassenden Strom führende Leiterbahn S-förmig ausgebildet ist;

Figur 3 zeigt eine Variante für eine Stromerfassungsanordnung in einer Aufsicht, wobei eine den zu erfassenden Strom führende Leiterbahn I-förmig ausgebildet ist.

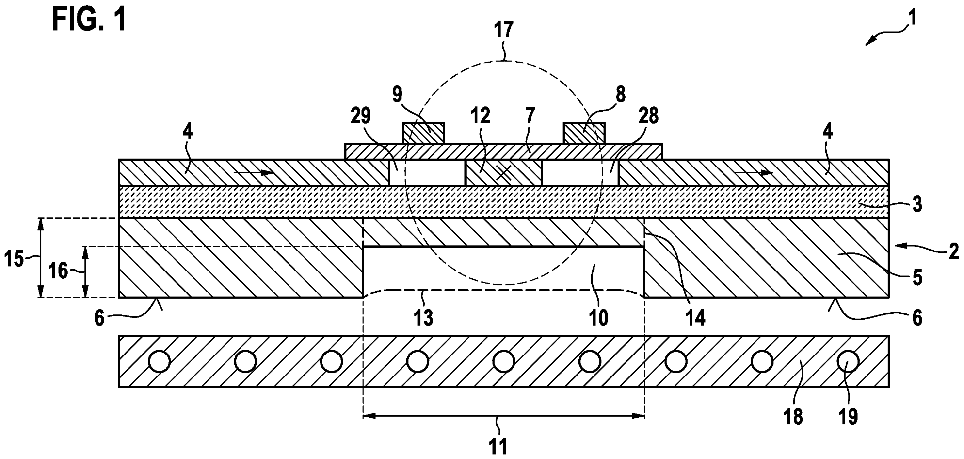

Figur 1 zeigt - schematisch - ein Ausführungsbeispiel für eine Stromerfassungsanordnung 1 in einer Schnittdarstellung. Die Stromerfassungsanordnung 1 umfasst einen in diesem Ausführungsbeispiel keramisch ausgebildeten Schaltungsträger 2. Der Schaltungsträger 2 weist eine elektrisch isolierende Schicht 3, insbesondere Keramikschicht auf. Der Schaltungsträger 2 weist auch eine elektrisch leitfähige Schicht 4, insbesondere Kupferschicht, auf. Die elektrisch leitfähige Schicht 4 bildet in diesem Ausführungsbeispiel eine Umverdrahtungsschicht, insbesondere eine Leiterbahn. Die elektrisch leitfähige Schicht 4, insbesondere Leiterbahn, ist ausgebildet, einen elektrischen Strom zu führen, und ist in diesem Ausführungsbeispiel S-förmig ausgebildet.

Der Schaltungsträger 2 weist auch eine elektrisch leitfähige, und wärmeleitfähige Rückseitenschicht 5 auf. Die Rückseitenschicht 5 ist mit der elektrisch isolierenden Schicht 3 stoffschlüssig verbunden. Die elektrisch leitfähige Schicht 4, und die Rückseitenschicht 5 schließen die elektrisch isolierende Schicht 3 - insbesondere nach Art eines Sandwichs - zwischeneinander ein.

Die Stromerfassungsanordnung 1 umfasst auch einen Stromsensor 7. Der Stromsensor 7 weist in diesem Ausführungsbeispiel zwei Hall-Sensoren 8 und 9 auf, welche zueinander beabstandet und ausgebildet sind, ein Magnetfeld 17 eines in der Leiterbahn 12 fließenden Stromes zu erfassen, wobei die Leiterbahn 12 Bestandteil der elektrisch leitfähigen Schicht 4 ist. Der Stromfluss ist in diesem Ausführungsbeispiel durch Pfeile in der elektrisch leitfähigen Schicht 4 gekennzeichnet. Die elektrisch leitfähige Schicht 4 ist im Bereich der Leiterbahn 12 S-förmig ausgebildet, wobei zu der Leiterbahn 12 benachbart - insbesondere in der ebenen Erstreckung des Schaltungsträgers 2 - zwei Aussparungen 28 und 29 gebildet sind, in denen sich das Magnetfeld 17, erzeugt durch einen in der Leiterbahn 12 fließenden Strom, ausbreiten kann. Der Hall-Sensor 8 ist im Bereich der Aussparung 28 angeordnet, und der Hall-Sensor 9 ist im Bereich der Aussparung 29 angeordnet.

Der Stromsensor 7, insbesondere die Hall-Sensoren 8 und 9, sind auf einem Flächenbereich 11 des Schaltungsträgers 2 angeordnet. Der Schaltungsträger 2, insbesondere die Rückseitenschicht 5, weist in dem Flächenbereich 11 entlang ihrer Dickenerstreckung 15, eine Ausnehmung 10 auf. Die Ausnehmung 10 weist eine Tiefenerstreckung 16 auf, und bildet so in der Rückseitenschicht 5 eine Senke, Mulde oder Wanne.

Die von dem Stromfluss in der Leiterbahn 12 erzeugten magnetischen Feldlinien des Magnetfeldes 17 können sich in der Aussparung 10 ausbreiten, ohne dort störende Wirbelströme zu erzeugen.

Die Aussparung 10 ist in diesem Ausführungsbeispiel mit Luft gefüllt.

Die Aussparung 10 kann in einer anderen Ausführungsform mittels eines von dem Material der Rückseitenschicht 5 verschiedenen Material gefüllt sein, wie durch die gestrichelte Linie 13 dargestellt.

Das Material der Rückseitenschicht 5 des Schaltungsträgers 2 ist beispielsweise Kupfer. Das Material der Füllung der Aussparung 10, wie durch die gestrichelte Linie 13 dargestellt, ist beispielsweise ein Lotmittel, insbesondere ein zinnhaltiges Lotmittel. Das Lotmittel weist einen größeren ohmschen Widerstand auf, als die Rückseitenschicht 5. Dadurch kann die Ausbreitung von Wirbelströmen in dem Lotmittel im Vergleich zur Rückseitenschicht 5, insbesondere Kupferschicht, erschwert sein.

Figur 1 zeigt auch eine Variante für eine Stromerfassungsanordnung, bei der sich die Ausnehmung 10, wie durch die gestrichelte Linie 14 dargestellt, sich vollständig entlang der Dickenerstreckung 15 in der elektrisch leitfähigen Rückseitenschicht 5 erstreckt. Die Ausnehmung 10 ist in diesem Ausführungsbeispiel, dargestellt durch die gestrichelte Linie 14, als Durchbruch in der Rückseitenschicht 5 ausgebildet, sodass sich die Ausnehmung 10 bis hin zur elektrisch isolierenden Schicht 3 erstreckt.

Die Stromerfassungsanordnung 1 zeigt in diesem Ausführungsbeispiel auch eine Wärmesenke 18, welche in diesem Ausführungsbeispiel zum Fluidführen ausgebildet ist, und dazu Fluidkanäle aufweist, von denen ein Fluidkanal 19 beispielhaft bezeichnet ist. Der Schaltungsträger 2 weist in diesem Ausführungsbeispiel eine Wärmekontaktfläche 6 auf, welche an einer von der elektrisch isolierenden Schicht 3 abgewandten Seite der Rückseitenschicht 5 ausgebildet ist. Der Schaltungsträger 2 ist ausgebildet, mit der Wärmekontaktfläche 6 mit der Wärmesenke 18 wärmeleitfähig verbunden zu werden. Dazu kann der Schaltungsträger 2 beispielsweise mittels eines Wärmeleitmittels mit der Wärmesenke 18 verbunden werden, oder mit der Wärmesenke 18 stoffschlüssig, beispielsweise mittels eines Lotmittels oder mittels eines wärmeleitfähigen Klebstoffs verbunden werden.

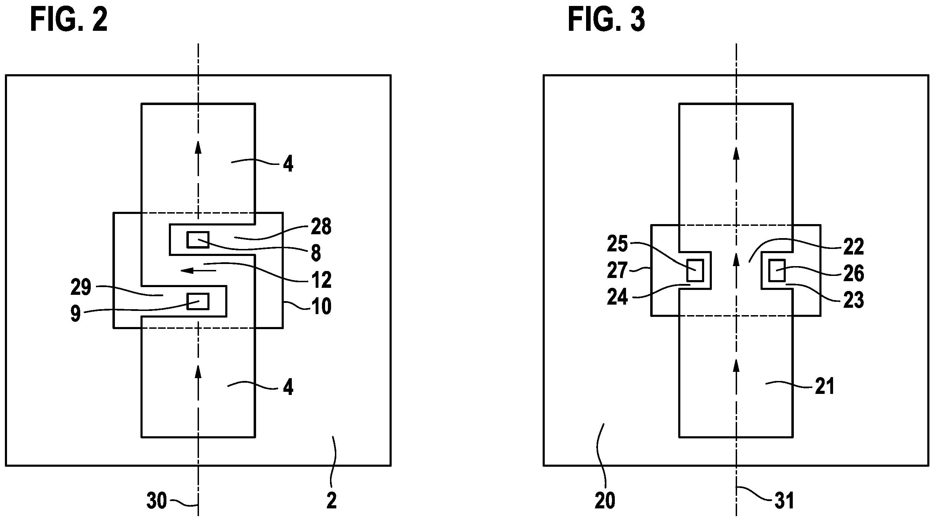

Figur 2 zeigt die in Figur 1 bereits dargestellte Stromerfassungsanordnung 1. Der Schaltungsträger 2 umfasst die als Leiterbahn ausgebildete elektrisch leitfähige Schicht 4, welche zum Führen eines Stroms, beispielsweise eines Phasenstroms einer Halbleiterschalter-Halbbrücke ausgebildet ist. Die Leiterbahn 4 weist in diesem Ausführungsbeispiel zwei quer zu einer Längserstreckung 30 der Leiterbahn 4 ausgebildete, in Figur 1 bereits dargestellte Ausnehmungen 28 und 29 auf. Die Leiterbahn 12 erstreckt sich zwischen den Ausnehmungen 28 und 29, sodass ein Strom in der Leiterbahn 12 quer zu einer durch die Längserstreckung 30 erzeugte Hauptstromrichtung in der elektrisch leitfähigen Schicht 4, welche die zwei Ausnehmungen 28 und 29 umgibt, fließen kann.

Der Hall-Sensor 8 ist im Bereich der Aussparung 28 angeordnet, und der Hall-Sensor 9 ist im Bereich der Aussparung 29 angeordnet, sodass die in Figur 1 bereits dargestellten Magnetfeldlinien des Magnetfelds 17 von den Hall-Sensoren 8 und 9 erfasst werden können.

Figur 2 zeigt auch die Aussparung 10 in der Rückseitenschicht 5. Die Aussparung 10 weist eine Flächenabmessung auf, welche - insbesondere in einer Orthogonalprojektion - die Aussparungen 28 und 29, und die Hall-Sensoren 8 und 9, und die Leiterbahn 12 abdeckt. Auf diese Weise können die in der Leiterbahn 12, insbesondere in Abhängigkeit des in der Leiterbahn 12 fließenden Stromes, erzeugten Magnetfeldlinien sich in dem Flächenbereich der Aussparung 10 in die Aussparung 10 hinein erstrecken.

Figur 3 zeigt ein Ausführungsbeispiel für eine Stromerfassungsanordnung mit einem Schaltungsträger 20, welche eine Variante zu der in den Figuren 1 und 2 dargestellten Stromerfassungsanordnung bildet. Der Schaltungsträger 20 weist eine elektrisch leitfähige Schicht 21 auf, welche eine Leiterbahn zum Führen eines elektrischen Stromes bildet. Die elektrisch leitfähige Schicht 21 weist entlang ihrer Längserstreckung 31 zwei einander gegenüberliegende, und sich quer zur Längserstreckung in der Leiterbahn 21 erstreckende Ausnehmungen 23 und 24 auf. Zwischen den Ausnehmungen 23 und 24 erstreckt sich ein Steg 22, dessen Breite kleiner ausgebildet ist, als die Breite der elektrisch leitfähigen Schicht 21 außerhalb der Aussparungen 23 und 24. Auf diese Weise kann ein Strom in der elektrisch leitfähigen Schicht 21 durch den Steg 22 fließen, und im Bereich des Stegs 22 ein Magnetfeld erzeugen, welches sich in den Aussparungen 23 und 24 - insbesondere den Steg 22 ringförmig umschließend - ausbreiten kann.

Die in Figur 3 gezeigte Stromerfassungsanordnung weist auch zwei Hall-Sensoren 25 und 26 auf, welche jeweils in einer der Aussparungen 23 beziehungsweise 24, oder in einer Projektion der Aussparungen 23 und 24 derart angeordnet sind, dass die Hall-Sensoren 25 und 26 ein sich in den Aussparungen 23 und 24 ausbreitendes Magnetfeld erfassen können.

Der Schaltungsträger 20 weist in diesem Ausführungsbeispiel eine elektrisch leitfähige und wärmeleitfähige Rückseitenschicht auf, in der eine flächige Vertiefung 27 ausgebildet ist. Die flächige Vertiefung 27 bildet in der Rückseitenschicht so eine Art Wanne oder Senke, in der sich die Magnetfeldlinien, erzeugt im Bereich des Steges 22, ausbreiten können. Der Flächenbereich der Ausnehmung 27 in der Rückseitenschicht umschließt in einer Orthogonalprojektion auch die elektrisch leitfähige Schicht 21, den Steg 22, und die Aussparungen 23 und 24, und so auch die Hall-Sensoren 25 und 26.

Die elektrisch leitfähige Schicht 21 ist in diesem Ausführungsbeispiel I-förmig ausgebildet, sodass - anders als bei der in Figur 2 dargestellten S-förmigen elektrisch leitfähigen Schicht, ein in der elektrisch leitfähigen Schicht 21 fließender Strom geradlinig ohne Umlenkungen durch den Steg 22 fließen kann.

## Patentansprüche

1. Stromerfassungsanordnung (1),
mit einem insbesondere keramischen Schaltungsträger (2),
wobei der Schaltungsträger (2) wenigstens eine oder nur eine elektrisch isolierende Schicht (3) und wenigstes einer elektrisch leitfähige Schicht (4, 5) aufweist, wobei der Schaltungsträger (2) eine mit der elektrisch isolierenden Schicht (3) verbundene elektrisch leitfähige Rückseitenschicht (5) aufweist, welche ausgebildet ist, mit einer Wärmesenke (18) wärmeleitfähig verbunden zu werden, wobei die elektrisch leitfähige Schicht (5) eine Leiterbahn (4, 12) bildet, welche ausgebildet ist, einen Strom zu führen,
wobei die Stromerfassungsanordnung (1) einen mit dem Schaltungsträger (2) verbundenen Stromsensor (7) zum Erfassen eines in der Leiterbahn (4, 12) fließenden Stromes aufweist, welcher im Bereich der Leiterbahn (12) angeordnet ist, und ausgebildet ist, ein von dem in der Leiterbahn (12) fließenden Strom erzeugtes Magnetfeld (17) zu erfassen,
**dadurch gekennzeichnet, dass**
die elektrisch leitfähige Rückseitenschicht (5) im Bereich des Stromsensors (7, 8, 9), insbesondere in einem zu dem Stromsensor (7, 8, 9) gegenüberliegenden Bereich, wenigstens eine oder nur eine Aussparung (10, 14, 27) aufweist.

2. Stromerfassungsanordnung (1) nach Anspruch 1,
**dadurch gekennzeichnet, dass**
mittels der Aussparung (10, 14, 27) eine sich entlang einer Schichtdicke (15) der Rückseitenschicht (5) erstreckende Wanne oder Vertiefung gebildet ist,

3. Stromerfassungsanordnung (1) nach Anspruch 1 oder 2,
**dadurch gekennzeichnet, dass**
die Rückseitenschicht für jeden Hallsensor (8, 9) eine Aussparung (10, 14, 27) aufweist, welche im Bereich des Hallsensors (8, 9) ausgebildet ist.

4. Stromerfassungsanordnung (1) nach einem der vorhergehenden Ansprüche,
**dadurch gekennzeichnet, dass**
die Aussparung (10, 14, 27) als Durchbruch (14) in der Rückseitenschicht (5) ausgebildet ist.

5. Stromerfassungsanordnung (1) nach einem der vorhergehenden Ansprüche,
**dadurch gekennzeichnet, dass**
die Aussparung (10, 14, 27) mit einer Vergussmasse, insbesondere Mold-Masse gefüllt ist.

6. Stromerfassungsanordnung (1) nach einem der vorhergehenden Ansprüche,
**dadurch gekennzeichnet, dass**
die Aussparung (10, 14, 27) mit einem von der Rückseitenschicht (5) verschiedenen elektrisch leitfähigen Material (13) gefüllt ist.

7. Stromerfassungsanordnung (1) nach Anspruch 6,
**dadurch gekennzeichnet, dass**
das Material (13) ein Lotmittel, insbesondere Lötzinn ist.

8. Stromerfassungsanordnung (1) nach einem der vorhergehenden Ansprüche,
**dadurch gekennzeichnet, dass**
der Stromsensor (7) ein differenzierender Hallsensor umfassend wenigstens zwei Hall-Sensorelemente (8, 9) ist.

9. Stromerfassungsanordnung (1) nach einem der vorhergehenden Ansprüche,
**dadurch gekennzeichnet, dass**
die Leiterbahn (4, 12) in Bereich des Stromsensors (7, 8, 9) mäanderförmig ausgebildet ist.

10. Stromerfassungsanordnung (1) nach einem der vorhergehenden Ansprüche,
**dadurch gekennzeichnet, dass**
die Leiterbahn (4, 12) im Bereich des Stromsensors (7, 8, 9) S-förmig ausgebildet ist.

11. Stromerfassungsanordnung (1) nach einem der vorhergehenden Ansprüche,
**dadurch gekennzeichnet, dass**
die Leiterbahn (21, 22) im Bereich des Stromsensors (7, 8, 9) I-förmig (22) ausgebildet ist.

12. Kommutierzelle (1) für einen Wechselrichter mit einer Stromerfassungsanordnung nach einem der vorhergehenden Ansprüche, wobei die Kommutierzelle wenigstens eine Halbleiterschalter-Halbbrücke, umfassend einen Low-Side-Halbleiterschalter und einen High-Side-Halbleiterschalter, umfasst und wobei die Kommutierzelle ausgebildet ist, den Strom für eine Phase des Wechselrichters zu erzeugen.

13. Wechselrichter für ein Elektrofahrzeug oder Hybridfahrzeug, wobei der Wechselrichter für jede Phase eine Kommutierzelle nach einem der vorhergehenden Ansprüche aufweist.
